Europäisches Patentamt

European Patent Office

Office européen des brevets

(11) Publication number: **0 139 431**
**B1**

(12) **EUROPEAN PATENT SPECIFICATION**

(45) Date of publication of patent specification: **06.07.88**

(51) Int. Cl.⁴: **H 05 K 3/34,** H 01 L 23/36

(21) Application number: **84306014.6**

(22) Date of filing: **03.09.84**

(54) Method of mounting a carrier for a microelectronic silicon chip.

<table>
<tr><td>

(30) Priority: **16.09.83 GB 8324839**

(43) Date of publication of application:
**02.05.85 Bulletin 85/18**

(45) Publication of the grant of the patent:
**06.07.88 Bulletin 88/27**

(84) Designated Contracting States:
**DE FR GB SE**

(56) References cited:
**CH-A- 614 810**
**DE-A-3 042 085**
**US-A-3 486 223**
**US-A-3 921 285**
**US-A-4 164 811**

</td><td>

(73) Proprietor: **LUCAS INDUSTRIES public limited company**
**Great King Street**
**Birmingham, B19 2XF West Midlands (GB)**

(72) Inventor: **Lewis, John David**
**43 Munsley Close**
**Matchborough Redditch B98 0BP (GB)**

(74) Representative: **Cuddon, George Desmond et al**
**MARKS & CLERK Alpha Tower Suffolk Street**
**Queensway**
**Birmingham B1 1TT (GB)**

</td></tr>
</table>

Courier Press, Leamington Spa, England.

## Description

This invention relates to a method of mounting onto a substrate a carrier for a microelectronic silicon chip.

Silicon chips are frequently mounted in chip carriers which are provided with terminal pads instead of external leads and are commonly known as leadless chip carriers, permitting increased packing density of the carriers on a printed circuit board.

Such chip carriers are typically square and are provided on all four sides with terminal pads which are electrically connected to conductors on a printed wiring board. The high packing densities obtainable with these components necessitate good thermal contact with a thermally conductive element on the printed wiring board. It is known to include a thermally conductive layer within the printed wiring board and to provide a thermally conductive paste, rubber or plastics material between the underside of each chip carrier and either the surface of the board or the thermally conductive layer, the latter being effected by local removal of an insulating layer of the board. Such an arrangement is liable to result in stress being applied to soldered joints between terminal pads and printed wiring conductors, as a result of differential thermal expansion between the solder and interposed thermally conductive material, in a direction normal to the plane of the board.

It is an object of the invention provide a method of reducing the thermal resistance between a silicon chip carrier and a supporting substrate, such that stresses due to differential expansion are reduced.

According to the invention there is provided a method of mounting a carrier of a microelectronic silicon chip onto an electrically insulating support within which is included a layer or two layers of high thermal conductivity material, said method including the steps of making a thermal connection between said layer or layers and an electrically insulating surface of said support at a location thereon where said carrier is to be secured, metallising a zone of a face of said carrier which is to lie adjacent said support, and soldering said metallised zone to said thermal connection by means of the solder which is used to secure terminals of the carrier to a wiring pattern on the support.

Embodiments of the invention will now be described by way of example only and with reference to the accompanying drawings in which:—

Figure 1 is a plan view of a micro-chip carrier;

Figure 2 shows, somewhat diagrammatically, an intermediate stage in attaching a chip carrier to a printed wiring board;

Figure 3 is a view, corresponding to Figure 2, showing the carrier attached to the board, and

Figure 4 shows an alternative embodiment of a thermal connection between a chip carrier and a multilayer substrate.

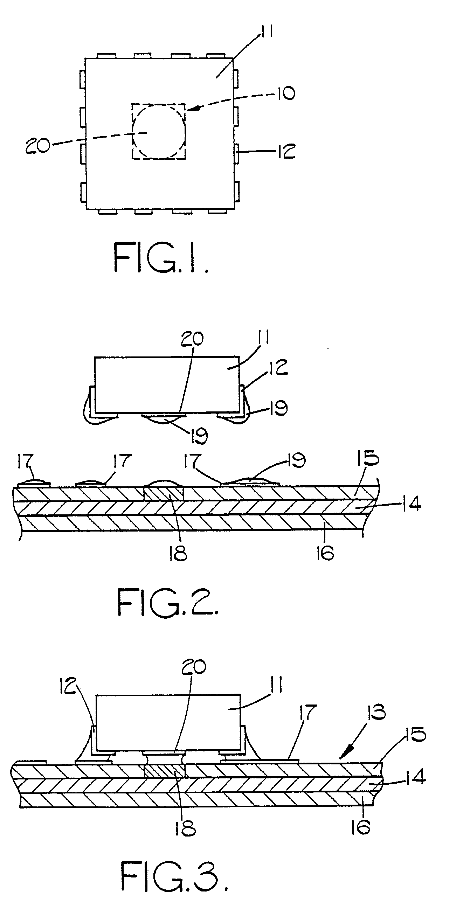

As shown in Figure 1 an electronic micro-chip, indicated at 10, is mounted within a carrier 11 which is square in plan view and which has on each of its sides terminals 12 for leads (not shown) from the chip 10.

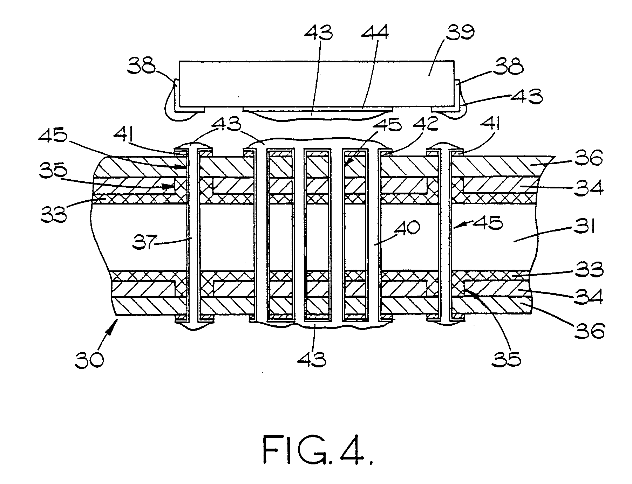

As shown in Figures 2 and 3 a printed wiring board 13 comprises a thermally conductive layer 14 which is sandwiched between two electrically insulating layers 15, 16. The outer surface of the layer 15 is provided, by any known means, with patterns of wiring 17 for providing interconnections between the terminals 12 and external connections or corresponding terminals on other chip carriers.

A portion of the layer 15 is removed, by boring or other suitable means, at a location which corresponds to the centre of a carrier 11 to be mounted on the board 13. The board 13 is then electro-plated, for example with copper, to provide a thermally conductive pad 18 between the layer 14 and the exposed surface of the layer 15. The underside of the carrier 11, adjacent the chip 10 is provided with a metallised zone 20, for example by vacuum deposition, plating or spraying, comprising successive layers of nickel-chrome alloy, nickel and gold. The terminals 12, the zone 20, the wiring 17 and the pad 18 are precoated with identical solder, as indicated at 19 in Figure 2. The carrier 11 is then located in its required position on the board 13 and the temperature is raised to that of melting point of the solder. Surface tension of the solder pulls the carrier 11 accurately into its required position on the board 13, as shown in Figure 3.

It will be understood that the board 13 could be a known type of double sided printed wiring board.

It will also be understood that the board 13 could alternatively comprise known type of multilayer substrate having a large number of wiring interconnections at different levels and provided with outer insulating layers corresponding to the layer 15 described above, one or both of the outer layers covering a thermally conductive layer corresponding to the layer 14.

Such a board 30 is shown in Figure 4 and comprises a multilayer substrate 31 of a known type which includes a plurality of insulating layers provided with through conductors known as "vias", and with embedded conductive connections, the vias passing between the substrate layers to contact selected ones of the aforesaid conductive connections, so as to provide required electrical connections between chip carriers or other components on both sides of the assembly. The substrate 31 is coated on both sides with insulating adhesive layers 33 and over these are located molybdenum sheets 34 having a high thermal conductivity and provided with apertures 35 at locations adjacent those where it has previously been determined that terminals of chip carriers will be positioned. Copper foil-clad insulating sheets 36 are adhesively mounted on the sheets 34, and the layers are pressed together to effect bonding and to cause the insulating adhesive 33 to flow into the apertures 35.

Holes 37 are drilled right through the boards 30 at required locations of the terminals 38 of chip carriers, only one such carrier being shown at 39.

The positions of the vias and/or the connections in the substrate 31 will have been designed so that the holes 37 will enable the necessary interconnections to be made between chip carriers and other components on the assembly.

Additionally a plurality of holes 40 are drilled through the board 30 to expose the molybdenum sheets 34 at locations which will lie under the bodies of the chip carriers 39. The copper foil on the sheets 36 and the insides of the holes 37, 40 are plated with copper 45 by the well-known through-plating technique. The plated foil layers are then etched, by known means, to provide a pattern of conductive lands 41 to which the terminals 38 of the carriers 39 are to be soldered, and to leave lands 42 around each group of holes 40.

Solder 43 is applied to the lands 41, 42 and preferably is allowed to pass into the holes 37, 40 by capillary action. The undersides of the carriers 39 are each provided with a metallized zone 44, as described above with reference to the first embodiment, and the same solder 43 is also applied to the zone 44 and the terminals 38. The carriers 39 are then located on the lands 41, 42 and the solder 43 is briefly reliquidised to complete the assembly.

**Claims**

1. A method of mounting a carrier (11 or 39) of a microelectronic silicon chip onto an electrically insulating support (13 or 30) within which is included a layer (14) or two layers (34) of material of high thermal conductivity, said method including the steps of making a thermal connection (18 or 45) between said layer (14) or two layers (34) and an electrically insulating surface (15 or 36) of said support (13 or 30) at a location thereon where said carrier (11 or 39) is to be secured, metallising a zone (20 or 44) of a face of said carrier (11 or 39) which is to lie adjacent said support (13 or 30) and securing said zone (20 or 44) to said thermal connection (18 or 45) by means of a thermally conductive material (19 or 43), characterised in that said zone (20 or 44) is soldered to said thermal connection (18 or 45) by means of the solder which is used to secure terminals (12 or 38) of the carrier (11 or 39) to a wiring pattern on the support (13 or 30).

2. A method as claimed in Claim 1 in which said thermal connection is made by forming a hole in said insulating surface (15 or 36) to expose said layer (14 or 34) of high thermal conductivity, and introducing a thermally conductive material (18 or 45) into said hole.

3. A method as claimed in Claim 2 in which said introduction of thermally conductive material (45) into said hole (40) is effected by plating.

4. A method as claimed in Claim 2 or Claim 3 in which solder (43) is introduced into said hole (40).

5. A method as claimed in Claim 2 or Claim 3 in which a plurality of said holes (40) are formed and a thermally conductive material (45) is introduced into each.

**Patentansprüche**

1. Verfahren zur Montage eines Trägers (11 oder 39) für ein mikroelektronisches Siliziumbauteil auf einer Halterung (13 oder 30), die ein Schicht (14) oder zwei Schichten (34) eines hochwärmeleitfähigen Materials enthält, wobei zwischen der Schicht (14) oder den beiden Schichten (34) und einer elektrisch isolierenden Oberfläche (15 oder 36) der Halterung (13 oder 30) eine thermische Verbindung (18 oder 45) an einer Stelle auf der Halterung, auf der der Träger (11 oder 39) befestigt werden soll, hergestellt wird, eine Zone (20 oder 44) einer Fläche des Trägers (11 oder 39), die der Halterung (13 oder 30) benachbart liegen soll, metallbeschichtet wird, und diese Zone (20 oder 44) an der thermischen Verbindung (18 oder 45) mit einem wärmeleitfähigen Material (19 oder 4)3 befestigt wird, dadurch gekennzeichnet, daß die Zone (20 oder 44) mit der thermischen Verbindung (18 oder 45) verlötet wird mit Hilfe des Lots, das zum Befestigen von Anschlüssen (12 oder 38) auf dem Träger (11 oder 39) an einer Verdrahtung auf der Halterung (13 oder 30) verwendet wird.

2. Verfahren nach Anspruch 1, wobei die thermische Verbindung hergestellt wird durch Ausbilden eines Lochs in der isolierenden Oberfläche (15 oder 36) unter Freilegung der hochwärmeleitfähigen Schicht (14 oder 34) und Einbringen eines wärmeleitfähigen Materials (18 oder 45) in das Loch.

3. Verfahren nach Anspruch 2, wobei das Einbringen von wärmeleitfähigem Material (45) in das Loch (40) durch Metallisieren erfolgt.

4. Verfahren nach Anspruch 2 oder 3, wobei Lot (43) in das Loch (40) eingebracht wird.

5. Verfahren nach Anspruch 2 oder 3, wobei eine Mehrzahl dieser Löcher (40) gebildet und ein wärmeleitfähiges Material (45) in jedes eingebracht wird.

**Revendications**

1. Méthode de montage d'un support (11 ou 39) d'une pastille de silicium pour microélectronique sur un organe-support électriquement isolant (13 ou 30) dans lequel une couche (14) ou deux couches (34) d'une matière à grande conductibilité thermique sont incluses, cette méthode comprenant les étapes de réalisation d'une connexion thermique (18 ou 45) entre ladite couche (14) ou les deux dites couches (34) et une surface électriquement isolante (15 ou 36) dudit organe-support (13 ou 30) à un emplacement de celui-ci où ledit support (11 ou 39) doit être fixé, de métallisation d'une zone (20 ou 44) d'une face dudit support (11 ou 39) qui doit se trouver adjacent audit organe-support (13 ou 30), et de fixation de ladite zone (20 ou 44) à ladite connexion thermique (18 ou 45) au moyen d'une matière thermiquement conductrice (19 ou 43), caractérisée en ce que ladite zone (20 ou 44) est soudée à ladite connexion thermique (18 ou 45) au moyen de la soudure qui est utilisée pour fixer les bornes (12 ou 38) du support (11 ou 39) à une configuration de conducteurs sur l'organe-support (13 ou 30).

2. Méthode selon la revendication 1, dans laquelle ladite connexion thermique est faite en formant ou trou dans ladite surface isolante (15 ou 36), pour mettre à découvert ladite couche (14 ou 34) à grande conductibilité thermique, et en introduisant une matière thermiquement conductrice (18 ou 45) dans ledit trou.

3. Méthode selon revendication 2, dans laquelle ladite introduction de matière thermiquement conductrice (45) dans ledit trou (40) est effectuée par placage.

4. Méthode selon revendication 2 ou 3, dans laquelle de la soudure (43) est introduite dans ledit trou (40).

5. Méthode selon revendication 2 ou 3, dans laquelle une pluralité de dits trous (40) est formée, et une matière thermiquement conductrice (45) est introduire dans chacun d'eux.

FIG.1.

FIG.2.

FIG.3.

FIG.4.